# FASCICULE DE BREVET EUROPEEN

(11) **EP 3 211 390 B1**
(45) Date de publication et mention de la délivrance du brevet: **26.01.2022**
(21) Numéro de dépôt: 17157579.8
(22) Date de dépôt: 23.02.2017
(51) Int. Cl.: G01J 5/02, G01J 5/20

(54) **DISPOSITIF DE DETECTION DE RAYONNEMENT ELECTROMAGNETIQUE A PLOT DE CONNEXION ELECTRIQUE SURELEVE**
VORRICHTUNG ZUR ERFASSUNG VON ELEKTROMAGNETISCHER STRAHLUNG MIT ERHÖHTER ELEKTRISCHER LÖTVERBINDUNG
DEVICE FOR THE DETECTION OF ELECTROMAGNETIC RADIATION WITH OVERHEAD ELECTRICAL CONNECTION PAD

(30) Priorité: 24.02.2016 FR 1651511
(43) Date de publication de la demande: 30.08.2017
(73) Titulaire: Commissariat à l'énergie atomique et aux énergies alternatives, 75015 Paris (FR); LYNRED, 91120 Palaiseau (FR)
(72) Inventeur: POCAS, Stephane, 38000 GRENOBLE (FR); ARNAUD, Agnès, 38420 SAINT JEAN LE VIEUX (FR); CORTIAL, Sébastien, 38360 SASSENAGE (FR); YON, Jean-Jacques, 38360 SASSENAGE (FR)
(74) Mandataire: INNOV-GROUP

(56) Documents cités:
- EP-A1- 1 041 371
- EP-A1- 2 743 659

## Description

### DOMAINE TECHNIQUE

Le domaine de l'invention est celui des dispositifs de détection de rayonnement électromagnétique, en particulier infrarouge ou térahertz, comportant au moins un plot de connexion électrique surélevé au-dessus d'un substrat contenant un circuit de lecture. L'invention s'applique notamment au domaine de l'imagerie et de la thermographie infrarouge.

### ÉTAT DE LA TECHNIQUE ANTÉRIEURE

Un dispositif de détection de rayonnement électromagnétique, par exemple infrarouge ou térahertz, comprend habituellement une matrice de détecteurs thermiques, dits élémentaires, chaque détecteur comportant une portion apte à absorber le rayonnement électromagnétique à détecter.

Dans le but d'assurer l'isolation thermique des détecteurs thermiques, les portions se présentent habituellement sous la forme de membranes suspendues au-dessus du substrat par des piliers d'ancrage, et sont isolées thermiquement de celui-ci par des bras d'isolation thermique. Ces piliers d'ancrage et bras d'isolation présentent également une fonction électrique en reliant électriquement les membranes suspendues à un circuit de lecture généralement disposé dans le substrat.

Le circuit de lecture se présente habituellement sous la forme d'un circuit CMOS. Il permet l'application d'un signal de commande aux détecteurs thermiques ainsi que la lecture de signaux de détection générés par les détecteurs thermiques en réponse à l'absorption du rayonnement électromagnétique à détecter. Le circuit de lecture comporte différents niveaux d'interconnexion électrique formés de lignes métalliques isolées électriquement les unes des autres par des couches diélectriques dites inter-métal. Un plot de connexion électrique du circuit de lecture est disposé sur le substrat de manière à pouvoir être contacté depuis l'extérieur du dispositif de détection.

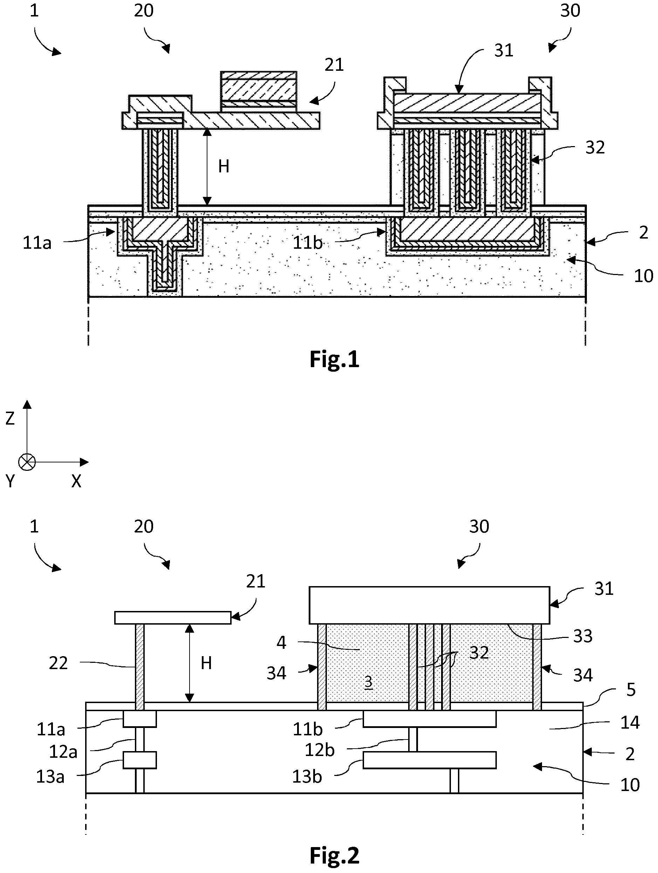

La figure 1 illustre un exemple de dispositif de détection 1 d'un rayonnement infrarouge, tel que décrit dans le document EP2743659, dont le plot de connexion électrique 30 comporte une portion métallique surélevée 31 vis-à-vis du substrat 2.

Le dispositif de détection 1 comporte une pluralité de détecteurs thermiques 20 dont chaque membrane absorbante 21 est suspendue au-dessus du substrat 2 à une distance H non nulle. Chaque membrane absorbante 21 est électriquement reliée à une portion 11a de ligne métallique du circuit de lecture 10, la ligne métallique appartenant ici à un avant dernier niveau d'interconnexion électrique d'un circuit CMOS.

Le dispositif de détection 1 comporte également un plot 30 de connexion électrique du circuit de lecture 10, qui comporte une portion métallique 31 surélevée au-dessus du substrat 2 et électriquement reliée à une deuxième portion 11b de la ligne métallique appartenant ici au même niveau d'interconnexion électrique. La portion métallique 31 est ici surélevée à une même distance H vis-à-vis du substrat 2 que la membrane absorbante 21, et est reliée au circuit de lecture 10 par des vias électriquement conducteurs 32.

Une couche sacrificielle est utilisée lors de la réalisation de la membrane absorbante 21 et de la portion métallique surélevée 31, puis est gravée de manière à suspendre la membrane absorbante 21. Une portion non gravée de la couche sacrificielle peut être présente au niveau du plot de connexion électrique 30, c'est-à-dire entre la portion métallique surélevée 31 et le substrat 2.

### EXPOSÉ DE L'INVENTION

L'invention a pour objectif de proposer un dispositif de détection de rayonnement électromagnétique comportant un plot de connexion électrique à portion métallique surélevée présentant une tenue mécanique améliorée. Pour cela, l'objet de l'invention est un dispositif de détection de rayonnement électromagnétique comportant :
- un circuit de lecture, situé dans un substrat ;
- un plot de connexion électrique, disposé sur le substrat, comportant une portion métallique, surélevée au-dessus du substrat et électriquement reliée au circuit de lecture.

Selon l'invention, il comprend :
- une paroi de protection, s'étendant sous la portion métallique surélevée de manière à délimiter avec celle-ci au moins une partie d'une cavité ;
- une portion de couche, dite de renfort, réalisée en un matériau minéral, située dans la cavité, et s'étendant sur toute la hauteur de la cavité, sur laquelle repose la portion métallique surélevée.

La paroi de protection présente une dimension longitudinale, ou longueur, et une épaisseur dans un plan parallèle au substrat, la dimension longitudinale étant supérieure à l'épaisseur, et de préférence au moins dix fois supérieure.

Par ailleurs, la portion de renfort est réalisée en un matériau minéral, de préférence un matériau à base d'oxyde de silicium.

Certains aspects préférés mais non limitatifs de ce dispositif de détection sont les suivants. La paroi de protection peut comporter plusieurs segments rectilignes, chaque segment présentant une dimension longitudinale et une épaisseur dans un plan parallèle au substrat, la dimension longitudinale étant supérieure à l'épaisseur, et de préférence au moins dix fois supérieure. Par segment rectiligne, on entend un segment qui s'étend longitudinalement, dans un plan parallèle au substrat, de manière rectiligne.

La portion de renfort peut présenter une étendue surfacique supérieure ou égale à 25%, de préférence 50% et de préférence encore 75%, d'une surface dite inférieure, orientée vers le substrat, de la portion métallique surélevée.

La paroi de protection peut s'étendre continûment de manière à délimiter une cavité fermée.

La paroi de protection peut s'étendre continûment de manière à délimiter une cavité ouverte localement.

Le dispositif de détection peut comporter au moins un détecteur thermique, disposé sur le substrat et électriquement relié au plot de connexion électrique par le circuit de lecture, et comportant une membrane adaptée à absorber le rayonnement électromagnétique à détecter et suspendue au-dessus du substrat à une distance de ce dernier sensiblement égale à celle séparant la portion métallique surélevée du substrat.

La paroi de protection peut être réalisée en un matériau électriquement conducteur, celle-ci reliant électriquement le plot de connexion électrique au circuit de lecture.

La paroi de protection peut entourer au moins un via électriquement conducteur reliant électriquement la portion métallique surélevée à une portion sous-jacente d'une ligne métallique du circuit de lecture.

La portion métallique surélevée peut présenter une surface inférieure, orientée vers le substrat, dont une dimension parallèle au substrat est supérieure ou égale à 2 fois, de préférence 10 fois, et de préférence 25 fois, la distance séparant ladite portion métallique surélevée du substrat suivant un axe sensiblement orthogonal au substrat.

Le plot de connexion électrique peut ne sensiblement pas comporter de portion de renfort hors de ladite cavité.

L'invention porte également sur un procédé de réalisation du dispositif de détection selon l'une quelconque des caractéristiques précédentes, dans lequel :
- on dépose, sur une couche d'arrêt de gravure recouvrant le substrat contenant le circuit de lecture, une couche sacrificielle ;
- on forme, au travers de la couche sacrificielle, une paroi de protection agencée de manière à délimiter ultérieurement au moins une partie d'une cavité ;
- on forme, sur la couche sacrificielle, une portion métallique surélevée, de sorte qu'elle repose sur la paroi de protection et participe à délimiter ladite cavité ;
- on grave au moins en partie la couche sacrificielle, une portion de la couche sacrificielle, dite portion de renfort, située dans ladite cavité et s'étendant sur toute la hauteur de la cavité, étant non gravée à la suite de cette étape de gravure.

La couche sacrificielle peut être réalisée en un matériau minéral, de préférence en un matériau à base d'un oxyde de silicium, et l'étape de gravure peut être effectuée par attaque chimique en milieu acide, de préférence à l'acide fluorhydrique en phase vapeur.

De manière concomitante à la formation de la paroi de protection, on peut former des piliers d'ancrage destinés à assurer le maintien mécanique de membranes absorbantes de détecteurs thermiques.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- la figure 2 est une vue schématique en coupe d'un dispositif de détection selon un mode de réalisation ;
- la figure 3a est une vue schématique de dessus du plot de connexion électrique du dispositif de détection illustré sur la figure 2, et la figure 3b est une vue schématique de dessus d'une variante du plot de connexion électrique illustré sur la figure 3a ;
- les figures 4a à 4g représentent les étapes d'un procédé de réalisation du dispositif de détection illustré sur la figure 2 ;
- les figures 5a et 5b sont des vues schématiques en coupe de variantes du dispositif de détection tel qu'illustré sur la figure 2.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures.

La figure 2 est une vue schématique en coupe transversale d'un dispositif de détection 1 d'un rayonnement électromagnétique selon un premier mode de réalisation.

On définit ici et pour la suite de la description un repère orthonormé tridimensionnel (X,Y,Z), où le plan (X,Y) est sensiblement parallèle au plan d'un substrat du dispositif de détection 1, l'axe Z étant orienté suivant une direction sensiblement orthogonale au plan du substrat 2. Ainsi, les termes « vertical » et « verticalement » s'étendent comme étant relatifs à une orientation suivant l'axe Z, et les termes « inférieur » et « supérieur » s'étendent comme étant relatifs à un positionnement croissant lorsqu'on s'éloigne du substrat suivant l'axe Z.

Dans cet exemple, le dispositif de détection 1 de rayonnement électromagnétique est adapté à détecter un rayonnement infrarouge ou térahertz. Il comporte une matrice de détecteurs thermiques 20 électriquement reliés à un circuit de lecture 10. La figure 2 est une vue partielle du dispositif de détection 1 et ne représente qu'un seul détecteur thermique 20 ici disposé au voisinage d'un plot de connexion électrique 30.

Le dispositif de détection 1 comprend un substrat 2, réalisé à base de silicium, comprenant un circuit électronique de lecture 10 réalisé en technologie CMOS permettant d'appliquer un signal de commande aux détecteurs thermiques 10 et de lire les signaux de détection générés par ceux-ci en réponse à une détection du rayonnement électromagnétique d'intérêt.

Le circuit de lecture 10 peut comporter une partie inférieure (non représentée) formée de dispositifs électroniques de type MOS, par exemple des transistors, diodes, condensateurs, adaptés à la mise en œuvre des différentes fonctions électroniques du circuit de lecture. Il comporte en outre plusieurs niveaux d'interconnexions électriques assurant les liaisons électriques entre les différents dispositifs MOS et les détecteurs thermiques, ainsi que la liaison électrique à au moins un plot de connexion électrique du circuit de lecture avec l'extérieur du dispositif de détection.

Le circuit de lecture 10 comporte ainsi plusieurs niveaux d'interconnexions électriques formés chacun d'une pluralité de lignes métalliques sensiblement planaires reliée aux lignes métalliques des niveaux inférieurs par des vias électriquement conducteurs, ou connexions verticales. Les différents niveaux d'interconnexions électriques sont séparés les uns des autres par des couches diélectriques, appelées diélectriques inter-métal (ou IMD, pour *Inter-Metal Dielectric,* en anglais), celles-ci étant traversées verticalement par les vias conducteurs. Chaque couche diélectrique inter-métal peut être réalisée en un oxyde de silicium SiOₓ ou un nitrure de silicium SiNₓ, voire en un alliage à base d'oxyde de silicium présentant une faible permittivité relative, tel que du SiOF, du SiOC, du SiOCH, etc...

Dans cet exemple, le circuit de lecture 10 comporte un niveau supérieur d'interconnexion métallique formé d'une première portion 11a de ligne métallique, située en regard d'un détecteur thermique 20, et destinée à être reliée électriquement à ce détecteur 20, et d'une seconde portion 11b de ligne métallique, située en regard d'un plot de connexion électrique 30, et destinée à être reliée électriquement à ce plot 30. Les portions 11a, 11b de ligne métallique de ce niveau d'interconnexion métallique sont reliées électriquement à des portions 13a, 13b de ligne métallique de niveau inférieur par des vias conducteurs 12a, 12b. Ces portions 11a, 11b et les vias conducteurs 12a, 12b sont isolés électriquement les uns des autres par une couche diélectrique inter-métal 14.

Le substrat 2 comporte en outre une couche d'arrêt de gravure 5 qui recouvre la surface formée par les portions 11a, 11b de ligne métallique et par la couche diélectrique inter-métal 14. Cette couche d'arrêt de gravure 5 est notamment adaptée à assurer une protection du substrat 2 et du circuit de lecture 10 vis-à-vis d'une attaque chimique, par exemple en milieu acide HF (acide fluorhydrique), mise en œuvre pour graver une partie d'une couche sacrificielle utilisée lors de la réalisation du dispositif de détection. Cette couche d'arrêt de gravure 5 forme ainsi une couche hermétique et chimiquement inerte assurant une protection des couches diélectriques inter-métal et des lignes métalliques sous-jacentes vis-à-vis de l'attaque chimique, et est électriquement isolante pour éviter tout court-circuit entre les portions de ligne métallique. La couche d'arrêt de gravure 5 peut être réalisée en alumine Al₂O₃, voire en nitrure ou fluorure d'aluminium. Elle peut présenter une épaisseur comprise entre quelques dizaines et quelques centaines de nanomètres, par exemple comprise entre 10nm et 500nm.

Sur le substrat 2 repose ici un détecteur thermique 20 comprenant une portion 21 adaptée à absorber le rayonnement à détecter. Cette portion absorbante 21 est isolée thermiquement du substrat 2 et peut être disposée au niveau d'une membrane, dite absorbante, suspendue au-dessus du substrat 2 par des éléments de maintien et d'isolation thermique tels que des piliers d'ancrage 22 associés à des bras d'isolation thermique (non représentés). Le pilier d'ancrage 22 est électriquement conducteur et traverse localement la couche d'arrêt de gravure 5 pour assurer un contact électrique avec la portion 11a de la ligne métallique. La membrane absorbante 21 est espacée du substrat 2 d'une distance H typiquement comprise entre 1µm et 5µm, par exemple 2µm environ quand les détecteurs sont conçus pour la détection d'un rayonnement infrarouge de longueur d'onde comprise entre 8µm et 14µm.

A titre illustratif, le détecteur thermique 20 peut être un bolomètre dont la membrane absorbante 21 comporte un matériau thermistance dont la conductivité électrique varie en fonction de l'échauffement de la membrane. Cependant, tout autre type de détecteur thermique peut être utilisé, par exemple des détecteurs pyroélectriques, ferroélectriques, voire des thermopiles.

Sur le substrat 2 repose également un plot de connexion électrique 30, destiné à permettre la connexion électrique du circuit de lecture 10 depuis l'extérieur du dispositif de détection 1, par exemple au moyen d'un câblage filaire (*wire bonding,* en anglais), voire d'un contact par pointe lors du test (*pin probing*) du dispositif de détection. Le plot de connexion électrique 30 comporte une portion métallique 31 surélevée au-dessus du substrat 2 et électriquement reliée à la portion 11b sous-jacente de ligne métallique du circuit de lecture 10.

La portion métallique surélevée 31 comporte une face supérieure qui forme une surface de contact pour la connexion électrique, et une face inférieure 33 opposée, orientée vers le substrat 2. La portion métallique 31 est ici surélevée au-dessus du substrat 2 à une distance sensiblement égale à la distance H de la membrane absorbante 21. Plus précisément, la face inférieure de la membrane absorbante 21 et la face inférieure 33 de la portion métallique surélevée 31 sont sensiblement coplanaires et situées à une même hauteur H vis-à-vis de la couche d'arrêt de gravure 5 du substrat. La portion métallique surélevée 31 peut être identique ou similaire à celle décrite dans le document EP2743659. Elle peut ainsi être formée d'un empilement de portions de couches de différents matériaux métalliques, par exemple une portion de nitrure de titane TiN recouverte d'une portion d'aluminium, elle-même étant éventuellement recouverte d'une portion de couche de TiN.

Le plot de connexion électrique 30 comporte dans cet exemple une pluralité de vias conducteurs 32 reliant électriquement la portion métallique surélevée 31 à la portion sous-jacente 11b de la ligne métallique du circuit de lecture 10. Les vias conducteurs 32 s'étendent de manière sensiblement verticale et contactent d'une part la portion métallique surélevée 31 et d'autre part la portion 11b de ligne métallique. Les vias conducteurs 32 peuvent être identiques ou similaires à ceux décrits dans le document EP2743659, et être ainsi formés d'une enveloppe de TiN ou de TiW entourant la périphérie d'un cœur en cuivre ou en tungstène. L'enveloppe de TiN ou de TiW peut assurer des fonctions de couche d'accroche et de couche barrière vis-à-vis de la diffusion éventuelle du cuivre. Les vias conducteurs 32 peuvent ainsi présenter une forme de tige ou de colonne, de section droite dans le plan (X,Y) sensiblement carrée présentant une surface comprise par exemple entre 0,25µm² et 5µm², et une hauteur sensiblement égale à la distance H. De manière avantageuse, les piliers d'ancrage 22 du détecteur thermique sont sensiblement identiques en termes de matériaux et de dimensions aux vias conducteurs 32 du plot de connexion électrique 30.

Le plot de connexion électrique 30 comporte également une paroi de protection 34, ou plusieurs parois 34 concentriques, qui s'étend(ent) continûment sous la portion métallique surélevée 31 de manière à délimiter, avec la face inférieure 33 de celle-ci, une cavité 3. Par délimiter, on entend que la paroi de protection 34 fixe au moins une partie des limites, dans le plan (X,Y), de la cavité ainsi formée. La portion métallique surélevée 31 repose sur la paroi de protection 34 et délimite ainsi verticalement, avec le substrat 2, la cavité 3. Celle-ci présente alors une hauteur suivant l'axe Z sensiblement égale à la hauteur H, et une étendue surfacique dans le plan (X,Y) dont le périmètre est au moins en partie défini par la paroi de protection 34.

La paroi de protection 34 s'étend suivant l'axe Z entre le substrat 2 et la portion métallique surélevée 31 et présente alors une hauteur sensiblement égale à la distance H. Elle s'étend longitudinalement suivant une distance délimitant au moins en partie la bordure de la cavité 3 dans le plan (X,Y). Elle présente enfin une épaisseur, dans le plan (X,Y), de l'ordre de quelques centaines de nanomètres à quelques microns, par exemple de l'ordre de 0,5µm. La paroi de protection 34 se distingue ainsi des piliers d'ancrage 22 et des vias conducteurs 32 en ce qu'elle présente une dimension dite longitudinale, ou longueur, supérieure à son épaisseur, par exemple 10 fois, 100 fois voire 2000 fois supérieure à son épaisseur. Elle peut être formée de manière similaire aux piliers d'ancrage 22 et aux vias conducteurs 32. Elle peut ainsi comporter un cœur, ou âme, en cuivre ou en tungstène intercalé entre deux couches verticales de TiN ou de TiW.

Le plot de connexion électrique 30 comporte également une portion 4 de couche d'un matériau de renfort située dans la cavité 3 ainsi délimitée par la paroi de protection 34. Comme il sera décrit plus loin, la portion de renfort 4 est avantageusement issue d'une couche sacrificielle utilisée lors de la réalisation de la membrane absorbante 21 et de la portion métallique surélevée 31. Elle peut ainsi être formée d'un matériau minéral, c'est-à-dire d'un matériau permettant la réalisation d'une couche diélectrique inter-métal, apte à être gravée par exemple par une attaque chimique à l'acide fluorhydrique (HF) en phase vapeur. A titre purement illustratif, ce matériau peut être un oxyde de silicium SiOx voire un alliage à base d'oxyde de silicium présentant éventuellement une faible permittivité relative, tel que du SiOF, du SiOC, du SiOCH, etc...

La portion de renfort 4 s'étend sur toute la hauteur de la cavité 3, de sorte que la portion métallique surélevée 31 repose au moins en partie sur la portion de renfort 4. Elle présente une étendue surfacique, dans le plan (X,Y), supérieure ou égale à 25% de la surface inférieure 33 de la portion métallique surélevée 31. De préférence, cette étendue surfacique de la portion de renfort 4 est supérieure ou égale à 50%, de préférence encore supérieure ou égale à 75%, voire à 80% et davantage, de la surface inférieure 33 de la portion métallique surélevée 31. Il n'y a sensiblement pas de portion de renfort 4 située hors de la cavité 3 au niveau du plot de connexion électrique 30, et, de préférence, au niveau des détecteurs thermiques 20. Dans cet exemple, les vias conducteurs 32 sont situés dans la cavité 3 et traversent verticalement la portion de renfort 4.

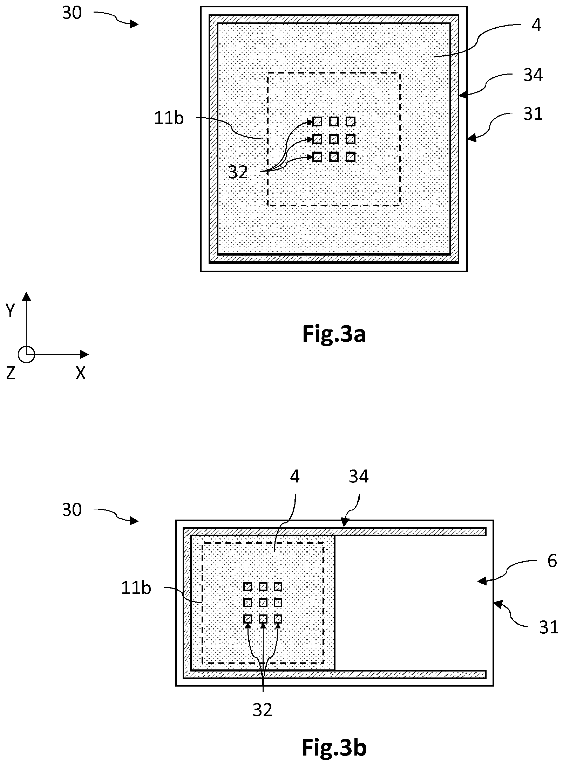

La figure 3a est une vue de dessus du plot de connexion électrique 30 illustré sur la figure 2. Le plot de connexion électrique 30 présente ici un portion métallique surélevée 31 de section droite dans le plan (X,Y) sensiblement carrée. D'autres formes sont possibles, par exemple rectangulaire voire polygonale, ou encore circulaire ou ovale. Il présente ici des dimensions dans le plan (X,Y) de l'ordre de quelques dizaines à quelques centaines de microns, par exemple 100µm de côté.

La paroi de protection 34 s'étend continûment sous la portion métallique surélevée 31, ici le long de la bordure circonférentielle de cette dernière, de manière à délimiter, avec le substrat 2 et plus précisément avec la couche d'arrêt de gravure 5, et avec la face inférieure 33 de la portion métallique surélevée 31, une cavité 3 ici fermée. La cavité 3 est dite fermée dans le sens où la paroi de protection 34 forme un périmètre fermé dans le plan (X,Y). La cavité fermée 3 est ici hermétique vis-à-vis d'une attaque chimique en milieu acide HF telle que décrite plus loin. Dans cet exemple, la paroi de protection 34 présente ici une épaisseur de l'ordre de 0,5µm, une hauteur suivant l'axe Z de l'ordre de 2µm et délimite une cavité 3 de surface carrée de l'ordre de 90µm de côté. Elle peut comporter un coeur en cuivre ou en tungstène intercalé entre deux couches verticales opposées l'une à l'autre et réalisées à base d'un alliage ou composé de titane.

La cavité fermée 3 est remplie d'une portion 4 de couche en un matériau de renfort, qui remplit ici entièrement la cavité 3. La portion de renfort 4 s'étend ainsi dans tout le volume de la cavité 3, de sorte que la portion métallique surélevée 31 repose au moins en partie sur la portion de renfort 4. La portion de renfort 4 est ici réalisée en une couche d'un matériau minéral, par exemple un oxyde de silicium.

Plusieurs vias conducteurs 32, d'une section droite dans le plan (X,Y) de 0,25µm², traversent verticalement la portion de renfort 4 et contactent ainsi la portion métallique surélevée 31 et la portion sous-jacente 11b de la ligne métallique. Ils assurent ainsi la connexion électrique de la portion métallique surélevée 31 au circuit de lecture 10.

Ainsi, le dispositif de détection 1 comporte un plot de connexion électrique 30 dont la portion métallique surélevée 31 présente un renforcement de sa tenue mécanique, par le fait qu'elle repose sur une portion de renfort 4 située dans la cavité 3 délimitée par la paroi de protection 34. Il est en effet possible, par l'agencement de la paroi de protection 34 vis-à-vis de la portion métallique surélevée 31, de maîtriser l'étendue surfacique de la portion de renfort 4 de sorte qu'elle présente une étendue suffisante permettant de renforcer la tenue mécanique de la portion métallique surélevée 31.

En effet, les inventeurs ont observé que la connexion électrique du dispositif de détection 1 par une mise en contact d'un élément électrique, par exemple un fil métallique, avec la portion métallique surélevée 31 peut provoquer l'application d'un effort mécanique sur le plot de connexion électrique, notamment un effort en cisaillement dans le plan (X,Y), pouvant engendrer un déplacement de la portion métallique surélevée 31 susceptible de dégrader la qualité de connexion électrique entre le plot de connexion électrique 30 et le circuit de lecture 10.

Les inventeurs ont alors mis en évidence que la portion métallique surélevée 31 du plot de connexion électrique 30 présente une tenue mécanique renforcée lorsqu'elle repose sur une portion 4 de couche de renfort dont l'étendue surfacique est contrôlée et au moins en partie préservée de l'attaque chimique par la paroi de protection 34. Il est alors possible d'assurer une étendue surfacique de la portion de renfort 4 telle qu'elle est supérieure ou égale à au moins 25% de la surface inférieure de la portion métallique surélevée, et de préférence supérieure ou égale à au moins 50%, voire 75% ou davantage. Comme décrit plus loin, la portion 4 de couche du matériau de renfort peut être issue de la couche sacrificielle utilisée lors de la réalisation de la membrane absorbante 21 et de la portion métallique surélevée 31.

La figure 3b est une vue schématique de dessus d'un plot de connexion électrique selon une variante du plot de connexion illustré sur la figure 3a.

Le dispositif de détection est similaire à celui décrit en référence à la figure 2 et s'en distingue essentiellement en ce que la paroi de protection 34 s'étend continûment de manière à délimiter une cavité 3 ouverte localement. Par cavité ouverte localement, on entend une cavité présentant au moins une ouverture 6 dans le plan (X,Y). La paroi de protection 34 ne forme alors pas un périmètre fermé. L'ouverture 6 présente ici une hauteur sensiblement égale à la distance H et une largeur dans le plan (X,Y) telle qu'à la suite d'une étape de gravure par attaque acide en milieu HF en phase vapeur, la portion de renfort 4 dans la cavité 3 présente une étendue surfacique, dans le plan (X,Y), supérieure ou égale à 25%, voire supérieure ou égale à 50% et de préférence supérieure ou égale à 75%, de la surface inférieure 33 de la portion métallique surélevée 31. La largeur de l'ouverture 6 est alors déterminée préalablement à la formation de la paroi de protection 34, en fonction notamment d'une estimation de la vitesse de gravure d'une portion de couche sacrificielle située sous la portion métallique surélevée 31 et en l'absence de paroi de protection 34, comme décrit plus loin.

Dans cet exemple, la paroi de protection 34 délimite une cavité 3 dont la section dans le plan (X,Y) présente une forme rectangle de surface 80µm×40µm. La paroi de protection 34 s'étend de manière à ce que la cavité 3 présente une ouverture 6 située ici au niveau d'un des deux côtés de 40µm de la cavité. Dans le cas d'une attaque acide par HF en phase vapeur d'une couche sacrificielle en oxyde de silicium, il a été observé que la vitesse de gravure sous la portion métallique surélevée 31 est supérieure, par exemple environ 20 fois supérieure, à la vitesse de gravure en-dehors de cette portion métallique surélevée 31. Ainsi, à titre illustratif, le temps nécessaire à la gravure de 2µm d'épaisseur d'une portion de couche sacrificielle située hors du plot de connexion 30 conduit à une gravure, sous la portion métallique surélevée 31, d'une portion de couche sacrificielle qui s'étend à partir de l'ouverture 6 suivant l'axe X sur une distance de 40µm. Ainsi, sous la portion métallique surélevée 31, une portion de couche sacrificielle d'une surface de 40µm×40µm est supprimée par gravure, et une portion 4 dite de renfort d'une surface de 40µm×40µm est préservée. La portion métallique surélevée 31 repose sur la portion de renfort 4 et sa tenue mécanique est alors renforcée. De manière avantageuse, les vias conducteurs 32 sont situés au niveau de la portion de renfort 4, et traversent celle-ci verticalement. De manière alternative ou complémentaire, des vias conducteurs 32 peuvent être situés dans la zone de la cavité 3 dépourvue de portion de renfort 4.

La paroi de protection 34 peut comporter plusieurs segments rectilignes, c'est-à-dire plusieurs parties de paroi de protection, qui s'étendent longitudinalement de manière rectiligne dans le plan (X,Y). Chaque segment présente une dimension longitudinale, ou longueur, et une épaisseur dans le plan (X,Y), la longueur étant supérieure à l'épaisseur, et de préférence au moins dix fois supérieure, c'est-à-dire supérieure ou égale à dix fois l'épaisseur. Les segments peuvent être joints deux à deux de manière à former ensemble la paroi de protection qui s'étend continûment, comme illustré sur les figures 3a et 3b. La jonction entre deux segments consécutifs peut présenter une forme courbe dans le plan (X,Y). En variante, les segments peuvent être disjoints deux à deux.

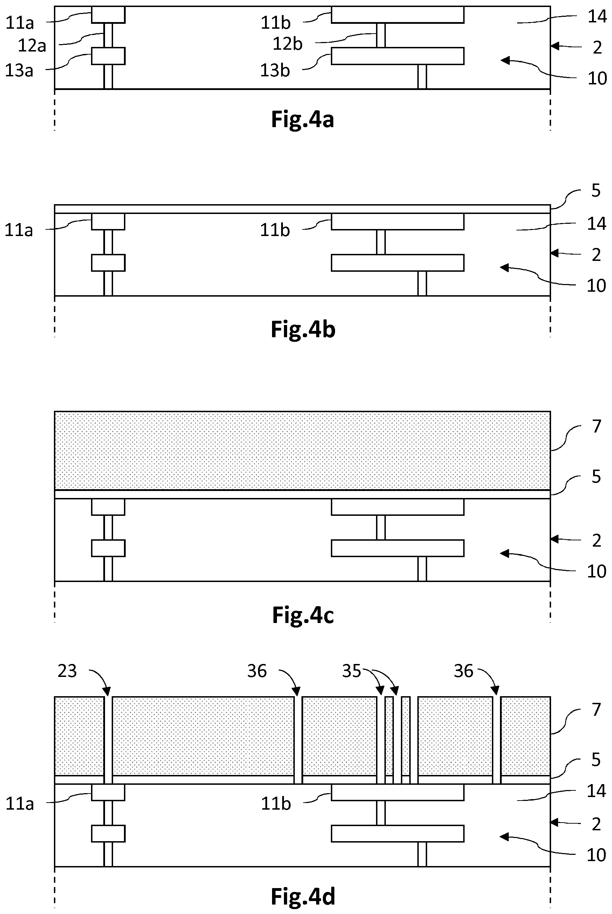

Les figures 4a à 4g illustrent différentes étapes d'un procédé de réalisation du dispositif de détection selon le premier mode de réalisation. Plusieurs étapes, hormis l'étape de formation de la paroi de protection 34, peuvent être similaires ou identiques à celles du procédé décrit dans le document EP2743659.

En référence à la figure 4a, on réalise un substrat 2 comportant un circuit de lecture 10 de type circuit CMOS. Le circuit de lecture 10 comporte ici un niveau d'interconnexion électrique comportant une première portion 11a et d'une deuxième portion 11b d'une ligne métallique. Les portions 11a, 11b sont électriquement reliées à des portions 13a, 13b de ligne métallique d'un niveau inférieur d'interconnexion électrique par des vias conducteurs 12a, 12b. Les vias et lignes métalliques sont séparés les uns des autres par des couches diélectriques inter-métal. Le substrat 2 comporte ici une face supérieure au niveau de laquelle affleurent les portions 11a, 11b de ligne métallique ainsi que la couche diélectrique inter-métal 14. Cette étape de réalisation du substrat peut être identique ou similaire à celle décrite dans le document EP2743659. Ainsi, à titre illustratif, les vias conducteurs 12a, 12b et les portions 11a, 11b, 13a, 13b de lignes métalliques peuvent être réalisés en cuivre ou en tungstène, par un procédé damascène dans lequel on remplit avec du cuivre des tranchées réalisées dans la couche diélectrique inter-métal. Le cuivre ou le tungstène peut éventuellement être intercalé transversalement entre des couches verticales en nitrure de titane, de tantale ou autre. L'affleurement des portions 11a, 11b de ligne métallique au niveau de la face supérieure de la couche diélectrique inter-métal 14 peut être obtenu par une technique de polissage mécano-chimique (CMP).

En référence à la figure 4b, on dépose ensuite une couche d'arrêt de gravure 5 sur la face supérieure du substrat 2. La couche d'arrêt de gravure 5 recouvre ainsi continûment la couche diélectrique inter-métal 14 ainsi que les portions 11a, 11b de ligne métallique. Elle peut être obtenue, à titre d'exemple, par un dépôt d'alumine Al₂O₃ effectué par ALD (pour *Atomic Layer Deposition,* en anglais). D'autres matériaux peuvent convenir, tels que du nitrure d'aluminium, du trifluorure d'aluminium, voire du silicium amorphe non intentionnellement dopé.

En référence à la figure 4c, on dépose sur la couche d'arrêt de gravure 5 une couche sacrificielle 7 en un matériau de préférence minéral, par exemple en oxyde de silicium déposé par PECVD (pour *Plasma Enhanced Chemical Vapor Deposition,* en anglais). Elle s'étend continûment sur sensiblement toute la surface du substrat 2 et recouvre la couche d'arrêt de gravure 5. L'épaisseur suivant l'axe Z de la couche sacrificielle 7 définit ultérieurement la distance H d'espacement entre la membrane absorbante 21 et le substrat 2, ainsi qu'entre la portion métallique surélevée 31 et le substrat 2. Elle dépend notamment des propriétés d'absorption des détecteurs thermiques que l'on souhaite obtenir, et peut être comprise entre 1µm et 5µm pour la détection de rayonnement infrarouge, par exemple être égale à 2µm environ.

En référence à la figure 4d, on réalise des orifices verticaux 23, 35 destinés à la formation des piliers d'ancrage 22 du détecteur thermique 20 d'une part et des vias conducteurs 32 du plot de connexion électrique 30 d'autre part. Ils sont réalisés par photolithographie et gravure, et traversent la couche sacrificielle 7 ainsi que la couche d'arrêt de gravure 5 pour déboucher respectivement sur la première portion 11a et la deuxième portion 11b de ligne métallique. Les orifices verticaux 23, 35 peuvent présenter une section droite dans le plan (X,Y) de forme carrée et de surface sensiblement égale ici à 0,25µm².

On réalise également une tranchée 36 destinée à la formation de la paroi de protection 34. La tranchée 36 est réalisée par photolithographie et gravure, et traverse la couche sacrificielle 7 jusqu'à déboucher ici sur la couche diélectrique inter-métal 14. Elle traverse donc également, dans cet exemple, la couche d'arrêt de gravure 5. La tranchée 36 s'étend longitudinalement dans le plan (X,Y) de manière à délimiter ultérieurement la cavité 3. Elle présente ici une épaisseur, ou largeur, dans le plan (X,Y) de dimension sensiblement égale à 0,5µm. De préférence, on réalise la tranchée 36 de manière concomitante, c'est-à-dire simultanée, à la réalisation des orifices verticaux 23, 35.

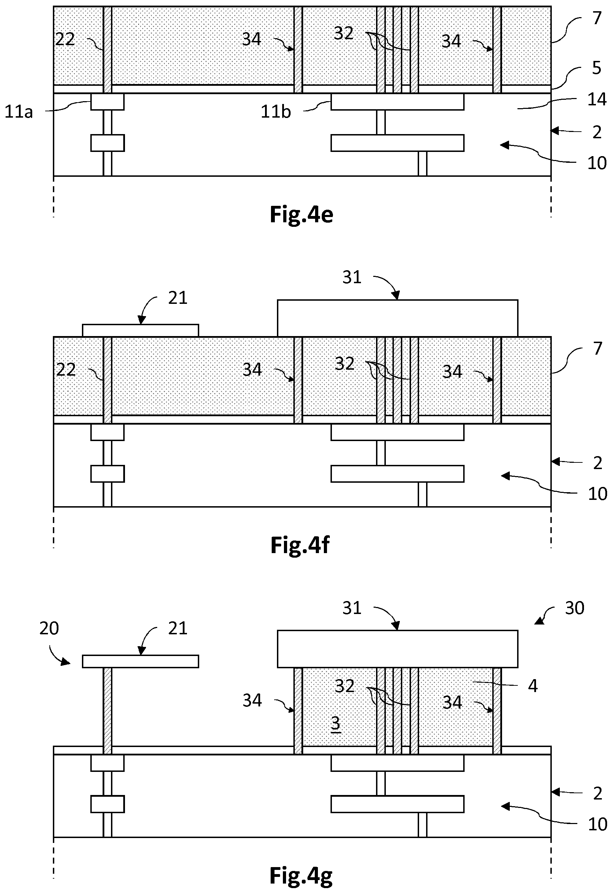

En référence à la figure 4e, on réalise ensuite des piliers d'ancrage 22 et des vias conducteurs 32 dans les orifices verticaux 23, 35 ainsi que la paroi de protection 34 dans la tranchée 36. Les piliers d'ancrage 22 et les vias conducteurs 32 peuvent être réalisés de manière identique en termes de dimensions et de matériaux. Ils peuvent être réalisés par remplissage des orifices 23, 35 par un ou plusieurs matériaux électriquement conducteurs. A titre d'exemple, ils peuvent comporter chacun une couche de TiN déposée par MOCVD (pour *Metal Organic Chemical Vapor Deposition,* en anglais) sur les flancs verticaux des orifices 23, 35, et un coeur en cuivre ou en tungstène remplissant l'espace délimité transversalement par la couche de TiN. La paroi de protection 34 peut être réalisée de manière concomitante à la formation des piliers d'ancrage 22 et des vias conducteurs 32, et de manière identique en termes de matériaux. Elle peut ainsi être formée par remplissage de la tranchée 36 d'une couche de TiN déposée par MOCVD sur les flancs verticaux de la tranchée 36 puis d'un coeur en cuivre ou en tungstène remplissant l'espace délimité transversalement par la couche de TiN. Une étape de CMP permet ensuite de planariser la surface supérieure formée par la couche sacrificielle 7, et par les vias conducteurs 32, les piliers d'ancrage 22 et la paroi de protection 34.

En référence à la figure 4f, on réalise la membrane suspendue 21 et la portion métallique surélevée 31. Cette étape peut être effectuée de manière identique ou similaire à celle décrite dans le document EP2743659 et n'est pas reprise en détail. Ainsi, la membrane absorbante 21 peut comporter un premier matériau adapté à absorber le rayonnement électromagnétique d'intérêt et un second matériau thermistance dont la conductivité électrique varie en fonction de l'échauffement de la membrane. La portion métallique surélevée 31 comporte une portion d'un matériau électriquement conducteur, par exemple de l'aluminium, éventuellement intercalé suivant l'axe Z entre deux portions de TiN. Ces portions conductrices sont réalisées de manière classique par dépôt, photolithographie puis gravure. La portion métallique surélevée 31 repose sur les vias conducteurs 32 qui assurent la connexion électrique avec le circuit de lecture 10. A titre illustratif, elle peut présenter une surface, dans le plan (X,Y), de l'ordre de 100µm×100µm.

En référence à la figure 4g, on effectue une gravure partielle de la couche sacrificielle 7 de manière à suspendre la membrane absorbante 21. La gravure peut être effectuée par une attaque chimique à l'acide fluorhydrique (HF) en phase vapeur. L'attaque chimique grave sensiblement toute la couche sacrificielle 7 située au niveau du détecteur thermique 20, permettant ainsi de suspendre la membrane absorbante 21 au-dessus du substrat 2. Une couche réflectrice (non représentée) est avantageusement située au niveau du substrat 2 en regard de la membrane absorbante 21 de sorte que l'espace vide forme une cavité optique de type quart d'onde renforçant l'absorption du rayonnement d'intérêt par le détecteur thermique. Au niveau du plot de connexion électrique 30, l'attaque chimique par HF vapeur grave la couche sacrificielle 7, à l'exception de la portion 4 de couche sacrificielle située dans la cavité fermée 3 délimitée par la paroi de protection 34. La portion non gravée 4 de la couche sacrificielle 7 forme ainsi la portion de renfort 4 sur laquelle repose la portion métallique surélevée 31, cette portion de renfort 4 venant renforcer la tenue mécanique de la portion métallique surélevée 31.

Les inventeurs ont constaté qu'une attaque chimique de la couche sacrificielle, en particulier d'une couche en un oxyde de silicium par un acide HF en phase vapeur, présente une première vitesse de gravure au niveau des détecteurs thermiques, et présente une seconde vitesse de gravure, sensiblement supérieure à la première vitesse, par exemple 5 fois supérieure, voire 10 fois supérieure et davantage, lorsque la portion de couche sacrificielle à graver est située sous la portion métallique surélevée. Les inventeurs ont ainsi observé que la vitesse de gravure par attaque chimique en HF vapeur augmente fortement lorsque la couche à graver est située dans une enceinte délimitée verticalement entre deux surfaces opposées l'une à l'autre, dont le rapport d'aspect L/H est supérieur ou égal à 2, L étant une dimension transversale de l'enceinte dans le plan (X,Y) et H étant la hauteur de l'enceinte suivant l'axe Z.

Dans cet exemple, l'enceinte délimitée verticalement par le substrat et la portion métallique surélevée présente une dimension L dans le plan (X,Y) de l'ordre de 100µm sur une hauteur H suivant l'axe Z de l'ordre de 2µm. La gravure de la portion de couche sacrificielle dans cette enceinte est alors près de 20 fois plus rapide que la gravure de la même couche sacrificielle hors de cette enceinte.

En effet, il apparaît que les produits de la réaction chimique de gravure de la couche sacrificielle, par exemple l'eau lorsque la couche sacrificielle est en oxyde de silicium, ne peuvent s'évacuer librement du fait d'un effet de confinement dans l'enceinte à rapport d'aspect L/H élevé. Les produits semblent alors agir comme catalyseurs de la gravure et augmentent sensiblement la vitesse de gravure dans l'enceinte.

Ainsi, en l'absence de paroi de protection 34, comme dans l'exemple décrit dans le document EP2743659 relatif à l'art antérieur, une grande partie de la couche sacrificielle située sous la portion métallique surélevée peut être gravée, ce qui peut conduire la portion métallique surélevée à reposer sur une portion de couche sacrificielle de trop faible étendue surfacique, se traduisant alors par une diminution de sa tenue mécanique.

Selon l'invention, la présence de la paroi de protection 34 permet de délimiter une cavité 3 dont tout ou partie de la portion de couche sacrificielle s'y trouvant est préservée de l'attaque chimique. On maîtrise ainsi l'étendue surfacique de la portion non gravée formant ainsi une portion de renfort 4 assurant une meilleure tenue mécanique de la portion métallique surélevée 31.

Dans l'exemple de la figure 3a, la cavité 3 est fermée et sensiblement hermétique vis-à-vis de l'attaque chimique par HF vapeur. Ainsi, la portion de couche sacrificielle située dans la cavité 3 n'est sensiblement pas gravée par l'attaque chimique, et forme alors une portion 4 de renfort de grande dimension sur laquelle repose la portion métallique surélevée 31. La tenue mécanique de cette portion 31 est alors sensiblement améliorée.

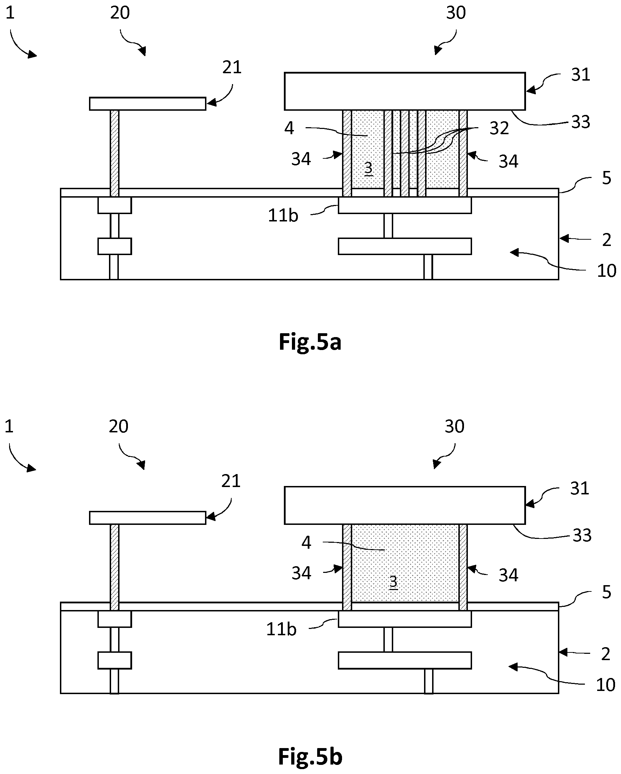

La figure 5a est une vue schématique en coupe d'un dispositif de détection 1 selon une variante de réalisation.

Le dispositif de détection 1 est similaire à celui décrit en référence à la figure 2 et s'en distingue essentiellement en ce que la paroi de protection 34 est en contact mécanique et électrique avec la portion 11b de ligne métallique. La paroi de protection 34, étant avantageusement électriquement conductrice, assure également une fonction de liaison électrique entre la portion métallique surélevée 31 et la portion 11b de ligne métallique du circuit de lecture 10. La connexion électrique est alors améliorée. Par ailleurs, les portions 11a et 11b de lignes métalliques assurent également une fonction de couche d'arrêt de gravure lors de la formation des orifices 23, 35 et de la tranchée 36 au-travers de la couche sacrificielle 7.

La taille de la portion 11b de ligne métallique peut alors être adaptée de sorte que la paroi de protection 34 délimite une cavité 3 dont l'étendue surfacique dans le plan (X,Y) est supérieure ou égale à 25%, 50%, 75% voire davantage de la surface inférieure 33 de la portion métallique surélevée 31.

La figure 5b est une vue schématique en coupe d'un dispositif de détection 1 selon une autre variante de réalisation.

Le dispositif de détection 1 est similaire à celui décrit en référence à la figure 5a et s'en distingue essentiellement en ce que le plot de connexion électrique 30 ne comporte pas de vias conducteurs 32, de sorte que la portion métallique surélevée 31 est électriquement reliée à la portion 11b de ligne métallique uniquement par la paroi de protection 34, celle-ci étant électriquement conductrice. La portion 11b de ligne métallique présente alors une forme, dans le plan (X,Y), adaptée à ce que la paroi de protection 34 soit en contact direct avec elle.

Des modes de réalisation particuliers viennent d'être décrits. Différentes variantes et modifications apparaîtront à l'homme du métier.

Ainsi, en variante au mode de réalisation illustré sur la figure 2 dans lequel la paroi de protection est en contact, au niveau de sa partie inférieure, avec la couche diélectrique inter-métal sous-jacente à la couche d'arrêt de gravure, la paroi de protection peut reposer sur la couche d'arrêt de gravure, et éventuellement sur des plots de support reposant sur la couche d'arrêt de gravure, comme décrit dans le document EP2840370.

## Revendications

1. Dispositif de détection (1) d'un rayonnement électromagnétique, comportant :
- un circuit de lecture (10), situé dans un substrat (2) ;
- un plot de connexion électrique (30), disposé sur le substrat (2), comportant une portion métallique (31), surélevée au-dessus du substrat (2) et électriquement reliée au circuit de lecture (10) ;
**caractérisé en ce qu'**il comprend :
- une paroi de protection (34), s'étendant sous la portion métallique surélevée (31) de manière à délimiter avec celle-ci au moins une partie d'une cavité (3), présentant une dimension longitudinale et une épaisseur dans un plan parallèle au substrat (2), la dimension longitudinale étant supérieure à l'épaisseur ;
- une portion (4) de couche, dite de renfort, réalisée en un matériau minéral, située dans la cavité (3) et s'étendant sur toute la hauteur de la cavité (3), sur laquelle repose la portion métallique surélevée (31).

2. Dispositif de détection (1) selon la revendication 1, dans lequel la portion de renfort (4) présente une étendue surfacique supérieure ou égale à 25%, de préférence 50% et de préférence encore 75%, d'une surface dite inférieure (33), orientée vers le substrat (2), de la portion métallique surélevée (31).

3. Dispositif de détection (1) selon la revendication 1 ou 2, dans lequel la paroi de protection (34) s'étend continûment de manière à délimiter une cavité (3) fermée.

4. Dispositif de détection (1) selon la revendication 1 ou 2, dans lequel la paroi de protection (34) s'étend continûment de manière à délimiter une cavité (3) ouverte localement.

5. Dispositif de détection (1) selon l'une quelconque des revendications 1 à 4, comportant au moins un détecteur thermique (20), disposé sur le substrat (2) et électriquement relié au plot de connexion électrique (30) par le circuit de lecture (10), et comportant une membrane (21) adaptée à absorber le rayonnement électromagnétique à détecter et suspendue au-dessus du substrat (2) à une distance de ce dernier sensiblement égale à celle séparant la portion métallique surélevée (31) du substrat (2).

6. Dispositif de détection (1) selon l'une quelconque des revendications 1 à 5, dans lequel la paroi de protection (34) est réalisée en un matériau électriquement conducteur, celle-ci reliant électriquement le plot de connexion électrique (30) au circuit de lecture (10).

7. Dispositif de détection (1) selon l'une quelconque des revendications 1 à 6, dans lequel la paroi de protection (34) entoure au moins un via électriquement conducteur (32) reliant électriquement la portion métallique surélevée (31) à une portion sous-jacente (11b) d'une ligne métallique du circuit de lecture (10).

8. Dispositif de détection (1) selon l'une quelconque des revendications 1 à 7, dans lequel la portion métallique surélevée (31) présente une surface inférieure (33), orientée vers le substrat (2), dont une dimension parallèle au substrat est supérieure ou égale à 2 fois, de préférence 10 fois, et de préférence 25 fois, la distance séparant ladite portion métallique surélevée (31) du substrat (2) suivant un axe sensiblement orthogonal au substrat (2).

9. Dispositif de détection (1) selon l'une quelconque des revendications 1 à 8, dans lequel le plot de connexion électrique (30) ne comporte sensiblement pas de portion de renfort (4) hors de ladite cavité (3).

10. Dispositif de détection (1) selon l'une quelconque des revendications 1 à 9, dans lequel la paroi de protection (34) comporte plusieurs segments rectilignes, chaque segment présentant une dimension longitudinale et une épaisseur dans un plan parallèle au substrat (2), la dimension longitudinale étant supérieure à l'épaisseur.

11. Procédé de réalisation du dispositif de détection (1) selon l'une quelconque des revendications précédentes, dans lequel :
- on dépose, sur une couche d'arrêt de gravure (5) recouvrant le substrat (2) contenant le circuit de lecture (10), une couche sacrificielle (7) ;
- on forme, au travers de la couche sacrificielle (7), une paroi de protection (34) agencée de manière à délimiter ultérieurement au moins une partie d'une cavité (3) ;
- on forme, sur la couche sacrificielle (7), une portion métallique surélevée (31), de sorte qu'elle repose sur la paroi de protection (34) et participe à délimiter ladite cavité (3) ;
- on grave au moins en partie la couche sacrificielle (7), une portion (4) de la couche sacrificielle, dite portion de renfort, située dans ladite cavité (3) et s'étendant sur toute la hauteur de la cavité (3), étant non gravée à la suite de cette étape de gravure.

12. Procédé selon la revendication 11, dans lequel la couche sacrificielle (7) est réalisée en un matériau minéral, de préférence en un matériau à base d'un oxyde de silicium, et en ce que l'étape de gravure est effectuée par attaque chimique en milieu acide, de préférence à l'acide fluorhydrique en phase vapeur.

13. Procédé selon la revendication 11 ou 12, dans lequel, de manière concomitante à la formation de la paroi de protection (34), on forme des piliers d'ancrage (22) destinés à assurer le maintien mécanique de membranes absorbantes (21) de détecteurs thermiques (20).

## Patentansprüche

1. Vorrichtung zur Detektion (1) einer elektromagnetischen Strahlung, aufweisend:
- eine Leseschaltung (10), die sich in einem Substrat (2) befindet;
- ein elektrisches Verbindungs-Pad (30), das auf dem Substrat (2) angeordnet ist, das einen metallischen Abschnitt (31) aufweist, der über dem Substrat (2) erhöht und mit der Leseschaltung (10) elektrisch verbunden ist;
**dadurch gekennzeichnet, dass** sie Folgendes umfasst:
- eine Schutzwand (34), die sich unter dem erhöhten metallischen Abschnitt (31) so erstreckt, dass sie mit diesem wenigstens einen Abschnitt eines Hohlraums (3) begrenzt, die eine Längsabmessung und eine Dicke in einer Ebene parallel zum Substrat (2) aufweist, wobei die Längsabmessung größer als die Dicke ist;
- einen Verstärkungsschichtabschnitt (4), der aus einem Mineralmaterial hergestellt ist, der sich in dem Hohlraum (3) befindet und sich über die gesamte Höhe des Hohlraums (3) erstreckt, auf dem der erhöhte metallische Abschnitt (31) aufliegt.

2. Detektionsvorrichtung (1) nach Anspruch 1, wobei der Verstärkungsabschnitt (4) eine Flächenerstreckung größer als oder gleich 25 %, vorzugsweise 50 % und besser noch 75 % einer Unterseite (33) des erhöhten metallischen Abschnitts (31), die in Richtung des Substrats (2) orientiert ist, aufweist.

3. Detektionsvorrichtung (1) nach Anspruch 1 oder 2, wobei sich die Schutzwand (34) durchgehend so erstreckt, dass sie einen geschlossenen Hohlraum (3) begrenzt.

4. Detektionsvorrichtung (1) nach Anspruch 1 oder 2, wobei sich die Schutzwand (34) durchgehend so erstreckt, dass sie einen lokal offenen Hohlraum (3) begrenzt.

5. Detektionsvorrichtung (1) nach einem der Ansprüche 1 bis 4, aufweisend mindestens einen Wärmedetektor (20), der auf dem Substrat (2) angeordnet und durch die Leseschaltung (10) mit dem elektrischen Verbindungs-Pad (30) elektrisch verbunden ist und eine Membran (21) aufweist, die geeignet ist, die zu detektierende elektromagnetische Strahlung zu absorbieren, und über dem Substrat (2) in einem Abstand zu letzterem aufgehängt ist, der im Wesentlichen gleich jenem ist, der den erhöhten metallischen Abschnitt (31) vom Substrat (2) trennt.

6. Detektionsvorrichtung (1) nach einem der Ansprüche 1 bis 5, wobei die Schutzwand (34) aus einem elektrisch leitenden Material hergestellt ist, wobei diese das elektrische Verbindungs-Pad (30) mit der Leseschaltung (10) elektrisch verbindet.

7. Detektionsvorrichtung (1) nach einem der Ansprüche 1 bis 6, wobei die Schutzwand (34) mindestens eine elektrisch leitende Durchkontaktierung (32) umgibt, die den erhöhten metallischen Abschnitt (31) mit einem darunter liegenden Abschnitt (11b) einer metallischen Leitung der Leseschaltung (10) elektrisch verbindet.

8. Detektionsvorrichtung (1) nach einem der Ansprüche 1 bis 7, wobei der erhöhte metallische Abschnitt (31) eine Unterseite (33) aufweist, die in Richtung des Substrats (2) orientiert ist, deren eine Abmessung parallel zum Substrat größer als oder gleich das 2-fache, vorzugsweise das 10-fache und vorzugsweise das 25-fache des Abstands ist, der den erhöhten metallischen Abschnitt (31) des Substrats (2) auf einer Achse trennt, die im Wesentlichen orthogonal zum Substrat (2) verläuft.

9. Detektionsvorrichtung (1) nach einem der Ansprüche 1 bis 8, wobei das elektrische Verbindungs-Pad (30) im Wesentlichen keinen Verstärkungsabschnitt (4) außerhalb des Hohlraums (3) aufweist.

10. Detektionsvorrichtung (1) nach einem der Ansprüche 1 bis 9, wobei die Schutzwand (34) mehrere geradlinige Segmente aufweist, wobei jedes Segment eine Längsabmessung und eine Dicke in einer Ebene parallel zum Substrat (2) aufweist, wobei die Längsabmessung größer als die Dicke ist.

11. Verfahren zur Herstellung der Detektionsvorrichtung (1) nach einem der vorhergehenden Ansprüche, wobei:
- auf einer Ätzstoppschicht (5), die das Substrat (2) bedeckt, das die Leseschaltung (10) enthält, eine Opferschicht (7) abgeschieden wird;
- durch die Opferschicht (7) eine Schutzwand (34) gebildet wird, die so angeordnet ist, dass sie später wenigstens einen Abschnitt eines Hohlraums (3) begrenzt;
- auf der Opferschicht (7) ein erhöhter metallischer Abschnitt (31) so gebildet wird, dass er auf der Schutzwand (34) aufliegt und daran beteiligt ist, den Hohlraum (3) zu begrenzen;
- die Opferschicht (7) wenigstens teilweise geätzt wird, wobei ein Abschnitt (4) der Opferschicht, der Verstärkungsabschnitt, der sich im Hohlraum (3) befindet, der sich über die gesamte Höhe des Hohlraums (3) erstreckt, nach diesem Schritt des Ätzens nicht geätzt ist.

12. Verfahren nach Anspruch 11, wobei die Opferschicht (7) aus einem Mineralmaterial hergestellt wird, vorzugsweise aus einem Material auf Basis eines Siliziumoxids, und dadurch, dass der Schritt des Ätzens durch chemisches Ätzen im sauren Milieu, vorzugsweise mit Fluorwasserstoff in der Dampfphase durchgeführt wird.

13. Verfahren nach Anspruch 11 oder 12, wobei gleichzeitig zur Bildung der Schutzwand (34) Verankerungssäulen (22) gebildet werden, die dazu bestimmt sind, den metallischen Halt von Absorptionsmembranen (21) von Wärmedetektoren (20) zu gewährleisten.

## Claims

1. Device (1) for detecting electromagnetic radiation, including:
- a read circuit (10) that is located in a substrate (2);
- an electrical connection pad (30), which is placed on the substrate (2), including a metal section (31) that is raised above the substrate (2) and electrically connected to the read circuit (10);
**characterized in that** it comprises:
- a protective wall (34) that extends under the raised metal section (31) so as to define therewith at least one portion of a cavity (3), and that has a longitudinal dimension and a thickness in a plane parallel to the substrate (2), the longitudinal dimension being larger than the thickness;
- what is called a reinforcing layer section (4), which is made from a mineral material and located in the cavity (3) and which extends over the entire height of the cavity (3) and on which the raised metal section (31) rests.

2. Detecting device (1) according to Claim 1, wherein the reinforcing section (4) has an areal extent that is larger than or equal to 25%, preferably 50% and more preferably 75% of that of what is called a lower surface (33), which is oriented toward the substrate (2), of the raised metal section (31).

3. Detecting device (1) according to Claim 1 or 2, wherein the protective wall (34) extends continuously so as to define a closed cavity (3).

4. Detecting device (1) according to Claim 1 or 2, wherein the protective wall (34) extends continuously so as to define a cavity (3) that is open locally.

5. Detecting device (1) according to any one of Claims 1 to 4, including at least one thermal detector (20) that is placed on the substrate (2) and electrically connected to the electrical connection pad (30) by the read circuit (10), and including a membrane (21) that is suitable for absorbing the electromagnetic radiation to be detected and that is suspended above the substrate (2) at a distance from the latter substantially equal to that separating the raised metal section (31) from the substrate (2).

6. Detecting device (1) according to any one of Claims 1 to 5, wherein the protective wall (34) is made from an electrically conductive material, said wall electrically connecting the electrical connection pad (30) to the read circuit (10).

7. Detecting device (1) according to any one of Claims 1 to 6, wherein the protective wall (34) encircles at least one electrically conductive via (32) electrically connecting the raised metal section (31) to a subjacent section (11b) of a metal line of the read circuit (10).

8. Detecting device (1) according to any one of Claims 1 to 7, wherein the raised metal section (31) has a lower surface (33), which is oriented toward the substrate (2), a dimension of which parallel to the substrate is larger than or equal to 2 times, preferably 10 times, and preferably 25 times, the distance separating said raised metal section (31) from the substrate (2) along an axis that is substantially orthogonal to the substrate (2).

9. Detecting device (1) according to any one of Claims 1 to 8, wherein the electrical connection pad (30) includes substantially no reinforcing section (4) outside of said cavity (3).

10. Detecting device (1) according to any one of Claims 1 to 9, wherein the protective wall (34) includes a plurality of rectilinear segments, each segment having a longitudinal dimension and a thickness in a plane parallel to the substrate (2), the longitudinal dimension being larger than the thickness.

11. Process for producing the detecting device (1) according to any one of the preceding claims, wherein:
- a sacrificial layer (7) is deposited on an etch-stop layer (5) covering the substrate (2) containing the read circuit (10);
- a protective wall (34) that is arranged so as to subsequently define at least one portion of a cavity (3) is formed through the sacrificial layer (7);
- a raised metal section (31) is formed, on the sacrificial layer (7), so that it rests on the protective wall (34) and participates in the definition of said cavity (3);
- the sacrificial layer (7) is at least partially etched, a section (4) of the sacrificial layer, called the reinforcing section, which is located in said cavity (3), and which extends over the entire height of the cavity (3), being unetched following this etching step.

12. Process according to Claim 11, wherein the sacrificial layer (7) is made of a mineral material and preferably of a material based on silicon oxide, and wherein the etching step is carried out by chemical attack in an acid medium and preferably in vapour-phase hydrofluoric acid.

13. Process according to Claim 11 or 12, wherein, concomitantly to the formation of the protective wall (34), anchoring pillars (22) are formed that are intended to mechanically support the absorbing membrane(s) (21) of the thermal detector(s) (20).
